# EUROPEAN PATENT SPECIFICATION

(11) **EP 1 199 380 B1**
(45) Date of publication and mention of the grant of the patent: **01.10.2008**
(21) Application number: 00985841.6
(22) Date of filing: 22.12.2000
(51) Int. Cl.: C23C 16/448, H01L 21/205, H01L 21/31

(54) **FILM FORMING DEVICE**
FILMHERSTELLUNGSVORRICHTUNG
DISPOSITIF FILMOGENE

(30) Priority: 22.12.1999 JP 36570099
(43) Date of publication of application: 24.04.2002
(73) Proprietor: TOKYO ELECTRON LIMITED, Minato-ku Tokyo 107-8481 (JP)
(72) Inventor: ASAKURA, Kentaro Tokyo Electron AT Limited, Nirasaki-shi, Yamanashi 407-0174 (JP); SHIMIZU, Takaya Tokyo Electron AT Limited, Nirasaki-shi, Yamanashi 407-0174 (JP)
(74) Representative: Liesegang, Eva
(86) International application number: PCT/JP2000/009153
(87) International publication number: WO 2001/046491

(56) References cited:
- EP-A- 0 786 804
- WO-A-98/14636
- JP-A- 7 201 829
- US-A- 5 635 244
- US-A- 5 963 834

## Description

### TECHNICAL FIELD

The present invention relates to a film deposition system for depositing a thin film on an object to be processed, such as a semiconductor wafer.

### BACKGROUND ART

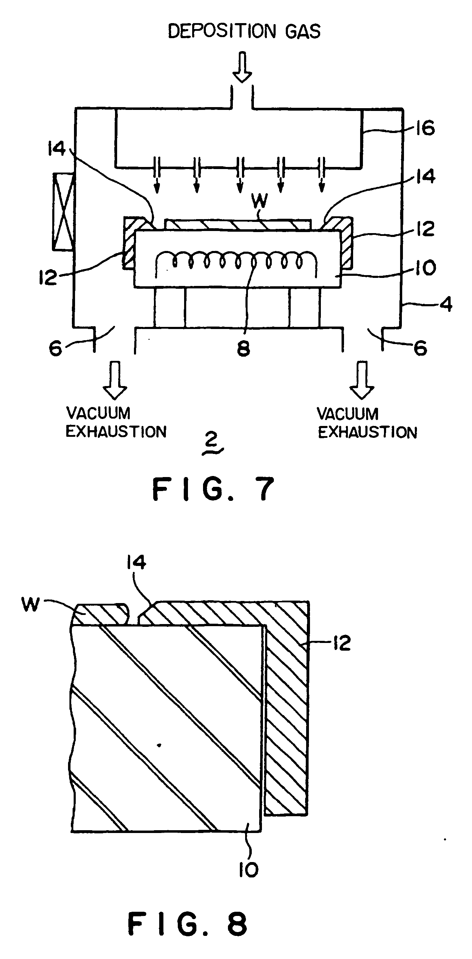

Generally, in a semiconductor integrated circuit fabricating method, various processes such as a film deposition process, an oxidation diffusion process and an etching process can be repeated to a semiconductor wafer as an object to be processed. A conventional single-wafer film deposition system will be briefly described with reference to Figs. 7 and 8. Fig. 7 is a schematic view of the conventional single-wafer film deposition system, and Fig. 8 is an enlarged view of a portion of Fig. 7. The film deposition system 2 has a cylindrical processing vessel 4 having a bottom wall provided with exhaust ports 6, through which gases contained in the processing vessel 4 can be evacuated to a vacuum state. A stage 10 including a heater 8 is placed in the processing vessel 4. A semiconductor wafer W as an object to be processed is mounted on an upper surface, i.e., a support surface, of the stage 10.

A guide ring 12 having a cross section resembling an inverted letter L is fitted on an upper peripheral part of the stage 10. An upper inner circumference of the guide ring 12 is tapered downward to form a guide surface 14. When mounting the wafer W on the support surface by means of lifter pins (not shown) that can support and lift up and move down the wafer W, a positional error of the wafer W may be prevented. As shown in Fig. 8, the guide ring 12 is disposed in close contact with the upper surface of the stage 10 with a very high dimensional accuracy.

A showerhead 16 is provided on a ceiling part of the processing vessel 4 facing the stage 10, in order to introduce one or more necessary gases such as a depositing gas into the processing vessel 4. A predetermined film can be deposited on a surface of the wafer W by making the depositing gas supplied through the showerhead 16 into the processing vessel 4 react in the processing vessel 4.

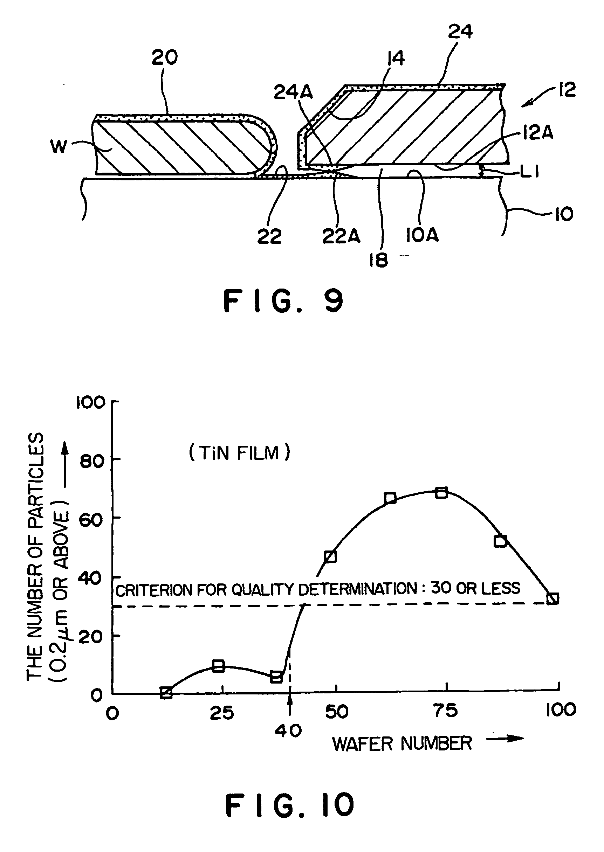

The guide ring 12 is fitted on the upper peripheral part of the stage 10 with a high dimensional accuracy. However, as shown microscopically in Fig. 9, a lower surface 12A of the guide ring 12 must be unavoidably in point contact with the support surface 10A i.e. the upper surface of the stage 10. Consequently, a small gap 18 of a height L1 on the order of 4 µm is formed inevitably between the surfaces 10A and 12A.

During a film deposition process, as shown in Fig. 9, while a desired film 20 is deposited on the surface of the wafer W, unnecessary films 22 and 24 may be also deposited unavoidably on the surfaces of the stage 10 and the guide ring 12, respectively. At that time, if there is the gap 18 as described above, a deposition rate is so high at an entrance (inner circumferential) region of the gap 18 that peak portions 22A and 24A having greater thicknesses may be generated. For example, when a desired thickness of the film 20 on the surface of the wafer W is on the order of 500 Å, it is possible that each thickness of the peak portions 22A and 24A is on the order of 1000 Å. That is, at the peak portions 22A and 24A, a deposition rate may be about twice that at which the film 20 is deposited.

The peak portions 22A and 24A may come off while the film deposition process to the wafer W is repeated. Thus, it is possible that the number of particles sharply increases. Fig. 10 is a graph showing a relationship between the number of processed wafers and the number of particles. As shown in Fig. 10, the number of particles (not smaller than 0.2 µm) sharply increases to a number far greater than a criterion number (for example, thirty) for quality determination after the number of processed wafers has exceeded forty. Data represented in the graph shown in Fig. 10 was obtained when a TiN film was deposited on wafers W.
EP 0 786 804 A1 describes a film deposition system including a stage where a substrate is held in a wafer chuck which is provided with a focusing ring for containing and directing the flow of process gas or plasma to the substrate. Between the focusing ring and the chuck a channel is provided, the channel having a size and geometry selected to regulate the radial flux of process gas across the peripheral edge of the substrate. The width of the channel is from about 1 to 1000 nm.
WO 98/14636 A1 describes a film deposition system including a chuck for holding a wafer and a focusing ring which is arranged along the side edges of the chuck. An annular space is provided between the chuck and the focusing ring, wherein a flow of clearance gas is provided to the annular space to prevent entry of process gas and volatile byproducts thereof into the annular space.

The present invention has been made to effectively solve the problem discussed with regard to figs. 7 to 10. Accordingly, it is an object of the present invention to provide a film deposition system capable of suppressing the emanation of particles even if a film deposition process is repeated.

### DISCLOSURE OF THE INVENTION

The inventors of the present invention made earnest studies of the deposition of a film on the guide ring, and found that there is a peak value of a film deposition rate where a partial pressure of a depositing (source) gas is lower than a certain level. Therefore, the emanation of particles can be suppressed if the guide ring has a part of a shape wherein the partial pressure of the depositing gas is lower and which makes it difficult for a deposited film to come off.

This invention is a film deposition system including: a processing vessel capable of being evacuated to make a vacuum therein; a stage placed in the processing vessel, capable of supporting an object to be processed thereon; and a guide ring placed on or above the stage so as to surround an outer circumference of the object to be processed mounted on the stage, capable of guiding the object to be processed onto the stage when mounting the object to be processed onto the stage; wherein a particle generation preventing space is formed between an inner peripheral part of a lower surface of the guide ring and an upper surface of the stage.

Thus, peak portions (ridges) of unnecessary films are formed on upper and lower wall surfaces defining the particle generation preventing space but not in the vicinity of an entrance (inside) edge of the guide ring. When the space has a thickness sufficiently great as compared with the thicknesses of the films deposited on the upper and the lower wall surfaces, the films deposited on the upper and the lower wall surfaces defining the particle generation preventing space do not touch each other, and hence it is scarcely possible that the films come off the upper and the lower wall surfaces. Thus, the generation (emanation) of particles can be remarkably prevented. Even if the deposited films come off the wall surfaces, it can be prevented that the particles are dispersed in a processing space or settle on the surface of the object to be processed, since the coming off of the deposited films may happen at a location other than the vicinity of the entrance edge of the particle generation preventing space.

The particle generation preventing space has a height of about 0.2 mm or above.

Preferably, the particle generation preventing space is a thin annular space. More preferably, the particle generation preventing space has a radial dimension of about 2 mm or above.

Preferably, the particle generation preventing space is defined by the flat upper surface of the stage and a step-like recessed portion formed at the lower surface of the guide ring.

Preferably, the particle generation preventing space is defined by the flat upper surface of the stage and a step-like recessed portion formed at the lower surface of the clamping ring.

### BRIEF DESCRIPTION OF THE DRAWINGS

Fig. 1 is a schematic view of a film depositing system according to the present invention;
Fig. 2 is an enlarged sectional view of a part of the stage and a part of the guide ring shown in Fig. 1;
Fig. 3 is an enlarged sectional view of a part A in Fig. 2 in a state where films are deposited;
Fig. 4 is a graph showing a relationship between flow rates of TiCl₄ gas as a source gas and film deposition rates on the stage;
Fig. 5 is a graph showing a change of the number of particles (0.2 µm or greater) when one hundred wafers were processed by a film deposition process;
Fig. 6 is a schematic view of a film depositing system in another embodiment according to the present invention;
Fig. 7 is a schematic view of a conventional film deposition system;
Fig. 8 is an enlarged view of a part of Fig. 7;
Fig. 9 is an enlarged view of a part of the film deposition system shown in Fig. 7; and
Fig. 10 is a graph showing a relationship between the number of processed wafers and the number of particles.

### BEST MODE FOR CARRYING OUT THE INVENTION

An embodiment of a film deposition system according to the present invention will be described with reference to the accompanying drawings.

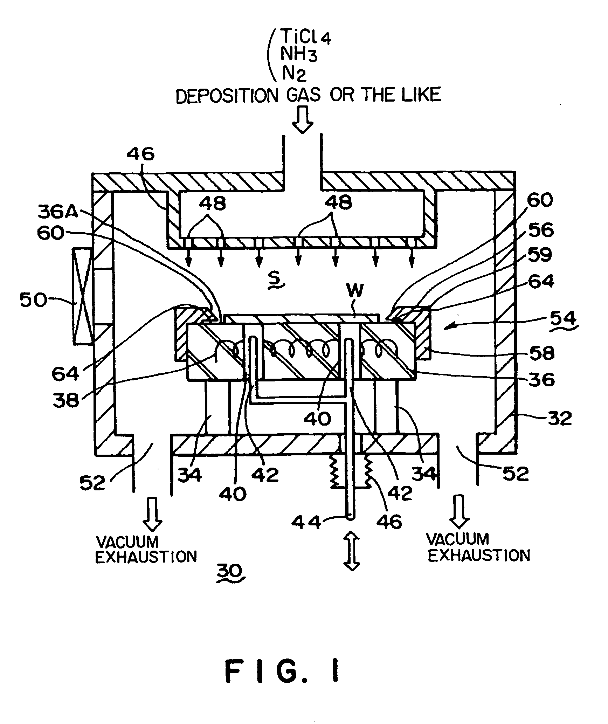

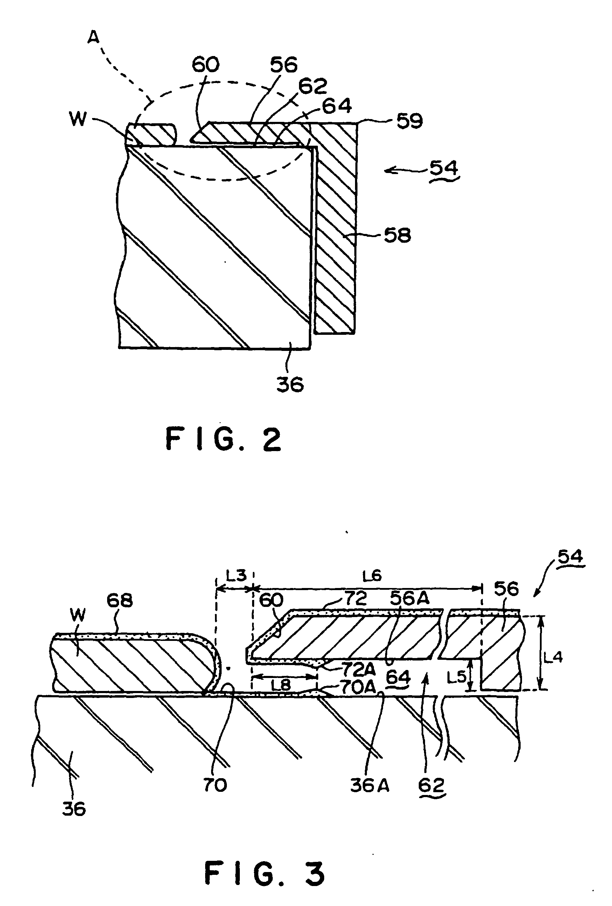

Fig. 1 is a schematic view of a film depositing system according to the present invention, Fig. 2 is an enlarged sectional view of a part of the stage and a part of the guide ring shown in Fig. 1, and Fig. 3 is an enlarged sectional view of a part A in Fig. 2 in a state where films are deposited. The film deposition system in the embodiment will be described as applied to depositing a TiN film.

Referring to Figs. 1 to 3, a film deposition system 30 has a cylindrical processing vessel 32 made of, for example, aluminum or the like. Supports 34 are set upright on a bottom wall of the processing vessel 32. Acylindrical stage 36 made of, for example, AlN is supported on the supports 34. A resistance-heater 38 is embedded in the stage 36. Thus, a semiconductor wafer W as an object to be processed, which has been placed on a support surface 36A of the stage 36 i.e. the upper surface of the stage 36 is adapted to be heated and maintained at a predetermined temperature.

The stage 36 is provided with, for example, three vertical through pin-holes 40 (only two of them are shown in Fig. 1). Lifter pins 42 having base end parts collectively connected to a support shaft 44 are inserted in the pin-holes 40, respectively. The support shaft 44 is vertically movably extended through a hole that is formed in the bottom wall of the processing vessel 32 and that is hermetically sealed by a bellows 46. When the support shaft 44 is moved vertically upward (or downward), the lifter pins 42 project upward (or disappear) from the support surface 36A of the stage 36 to lift up the wafer W.

The ceiling part of the processing vessel 32 facing the stage 36 is provided with a showerhead 46, through which one or more necessary gases including one or more depositing (source) gases are supplied into the processing vessel 32. The necessary gases including the source gases supplied into the showerhead 46 are adapted to be jetted into a processing space S through jetting holes 48 formed in a lower wall (jetting surface) of the showerhead 46. The processing vessel 32 is provided with a gate valve 50, which is opened and closed when carrying a wafer W into and carrying the same out of the processing vessel 32. Exhaust ports 52 are formed in peripheral parts of the bottom wall of the processing vessel 32. The exhaust ports 52 are connected to an exhaust system provided with a vacuum pump or the like. Thus, the processing vessel 32 can be evacuated to a predetermined pressure.

A guide ring 54, which has a feature of the present invention, is put on an upper peripheral part of the stage 36. More concretely, the guide ring 54 has a cross section of a shape resembling an inverted letter L, is formed of a ceramic material, such as Al₂O₃, or quartz glass, and is fitted closely on the upper peripheral part of the stage 36. The guide ring 54 has a guide ring body 59, which has a horizontal part 56 extending in parallel to the support surface 36A of the stage 36 and a vertical part 58 in contact with the side surface of the stage 36. An inner circumference of the horizontal part 56 is tapered downward and toward a center of the stage 36 to form a tapered guide surface 60. Thus, when lowering a wafer W supported on the lifter pins 42 to mount the wafer W on the support surface 36A, if there is a positional error of the wafer W, the guide surface 60 corrects the positional error of the wafer W and guides the wafer W to a correct position on the support surface 36A.

An annular cut-off portion 62 having a substantially fixed thickness (see Figs. 2 and 3) is formed at an inner peripheral part of the lower surface of the horizontal part 56 of the guide ring body 59. Thus, the inner peripheral part of the horizontal part 56 is thin, and a particle generation preventing space 64 having a shape of a very thin ring with a cross section resembling an elongate rectangle is formed between an under surface 56A of the part 56 and the support surface 36A of the stage 36.

Dimensions of those parts will be described by way of example with reference to Fig. 3. A distance L3 between an outer edge of the wafer W mounted at the correct position and an inside edge of the horizontal part 56 of the guide ring 54 is in a range of 0.5 to 1.5 mm, for example, on the order of 1 mm, regardless of a dimension of the diameter of the wafer W. A thickness L4 of the horizontal part 56 is in a range of 1.5 to 3 mm, for example, on the order of 2 mm. A height of the annular cut-off portion 62, namely, a height L5 of the particle generation preventing space 64, is 0.2 mm or above, for example, on the order of 0.3 mm. (In Fig. 3, the particle generation preventing space 64 is exaggerated for convenience of explanation.) A stage-radial length L6 of the particle generation preventing space 64 is 2 mm or above, for example, on the order of 3 mm. In the case, preferably, the ratio of the height to the length of the cross section of the particle generation preventing space 64, i.e., L6/L5, is set to be 10 or above. The thickness 0.2 mm of L5 is substantially equal to a limit depth of machining.

The operation of film deposition system as applied to, for example, depositing a TiN (titanium nitride) film will be described.

A semiconductor wafer W is carried onto and received by the lifter pins 42, via the opened gate valve 50. The liter pins 42 are lowered to mount the wafer W on the support surface 36A of the stage 36. If there is a positional error of the wafer W, the tapered guide surface 60 of the guide ring 54 fitted on the peripheral part of the stage 36 contacts with the outer periphery of the wafer W and corrects the positional error of the wafer W. Thus, the wafer W is placed at a correct position on the stage 36.

After the wafer W has been thus loaded, the wafer W is heated up to and maintained at a predetermined process temperature. At the same time, the processing vessel 32 is evacuated to make a vacuum therein, and predetermined gases such as the deposition (source) gases are supplied into the processing vessel 32. Thus, a film is deposited on the wafer W.

As the deposition gases, for example, TiCl₄ gas, NH₃ gas and N₂ gas may be used. In the case, a Tin film may be deposited. The wafer W may be an 8 inch wafer. Process conditions for forming a 500 Å thick TiN film on the wafer W are, for example, a TiCl₄ flow rate of about 20 sccm, an NH₃ flow rate of abut 400 sccm, an N₂ flow rate of about 50 sccm, a process temperature of about 680 °C, a process pressure of about 40 Pa (0.3 Torr) and a process time of about 60 s.

When the above film deposition process is repeated, as shown in Fig.3, while desired films 68 are deposited on wafers W, unnecessary films 70 and 72 may be also deposited on the surfaces of the support surface 36A and the guide ring 54. Unnecessary films are deposited also on the upper and the lower wall surfaces defining the particle generation preventing space 64. The thickness of the unnecessary films 70 and 72 increases gradually in proportion to the number of processed wafers W. Particularly, peak portions 70A and 72A of the films 70 and 72 are respectively formed in regions in the particle generation preventing space 64 where a partial pressure of the TiCl₄ gas as a source gas is low and a film deposition rate is high.

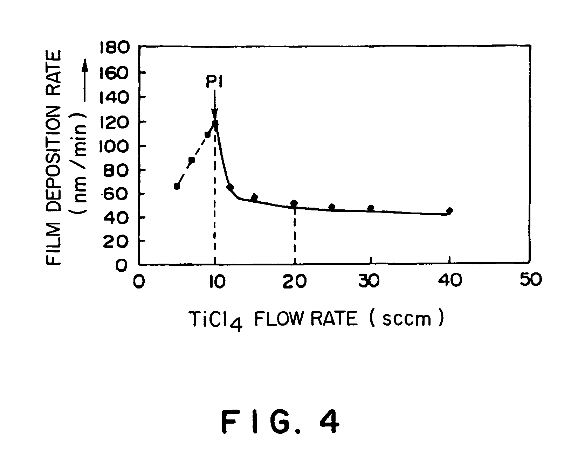

The peak portions 70A and 72A are formed at a radial distance L8 of, for example, about 2.8 mm from the inner circumference of the guide ring 54, i.e., at a radial distance L8 from the inner circumference of the guide ring 54 into the depth of the particle generation preventing space 64. Causes of formation of such peak portions 70A and 72A will be described with reference to Fig. 4. Fig. 4 is a graph showing a relationship between the flow rates of TiCl₄ gas as a source gas and the deposition rates on the stage. Herein, process conditions are the same as the aforesaid process conditions, except the flow rate of the TiCl₄ gas. As obvious from the graph of Fig. 4, the film deposition rate increases gradually as the flow rate of TiCl₄ gas is increased, in an initial stage of variation of the flow rate. However, after the film deposition rate has reached a peak P1 (when the flow rate of TiCl₄ gas is about 10 sccm), it decreases sharply. Then, the film deposition rate remains substantially constant on a relatively low level, regardless of the further increase of the flow rate of TiCl₄ gas. As mentioned above, since the flow rate of TiCl₄ gas is about 20 sccm in this case, the peak P1 of film deposition rate appears in a region where the flow rate of TiCl₄ gas is lower than about 20 sccm and the partial pressure of TiCl₄ gas is low.

As shown in Fig. 3, the region where the partial pressure of TiCl₄ gas as a source gas is low is a region where the partial pressure thereof decreases to a some extent by diffusing the TiCl₄ gas into the particle generation preventing space 64, that is, a portion toward the depth of (on the outer-periphery side of) the particle generation preventing space 64. Thus, the peak portions 70A and 72A are formed, for example, at the radial distance L8 toward the depth of the particle generation preventing space 64. Naturally, the distance L8 may be varied with the process conditions, the height L5 of the particle generation preventing space 64 and so on. The height L5 may be determined taking into consideration a cleaning cycle of the film deposition system, a film deposition rate, and so on.

As described above, according to the embodiment, the inner peripheral part of the lower surface of the horizontal part 56 of the guide ring body 59 is recessed to form the particle generation preventing space 64. The height L5 of the particle generation preventing space 64 is set to be about 0.3 mm, which is far greater than the thickness of the film to be deposited. Therefore, the peak portions 70A and 72A do not touch each other even if the respective peak portions 70A and 72A of the films 70 and 72 grow large. Thus, the peak portions 70A and 72B do not come off, and the emanation of particles can be suppressed.

For example, suppose that the thickness of the peak portions 70A and 72A of films deposited in one film deposition cycle is 500 Å (0.05 µm). Then, the thickness of the peak portions 70A and 72A after one hundred wafers have been processed is 5 µm (=0.05 x 100), and the sum of the respective thicknesses of the two peak portions 70A and 72A is 10 µm. Thus, the height L5 = 0.3 mm (= 300 µm) is far greater than 10 µm. Consequently, the peak portions 70A and 72A never touch each other. The film deposition system is cleaned to remove the unnecessary films 70 and 72 including the peak portions 70A and 72A after a predetermined number of wafers have been processed.

Even if the peak portions 70A and 72B of the films 70 and 72 peel off the wall surfaces, the peeled films accumulate in the region toward the depth of the particle generation preventing space 64. Accordingly, the peeled films do not disperse as particles into the processing space S, and the particles do not settle on the surfaces of wafers W.

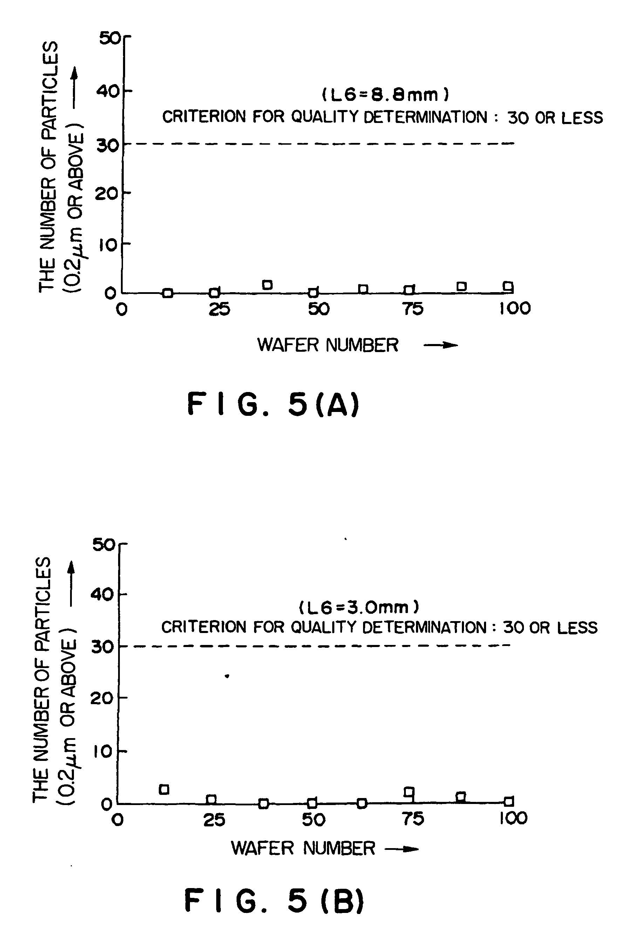

One hundred wafers were processed by the film deposition process under the aforesaid process conditions. Particles state in the case will be explained with reference to Fig. 5.

Fig. 5 shows changes in the number of particles (0.2 µm or greater) when one hundred semiconductor wafers were processed successively by the film deposition process. Figs. 5(A) and 5(B) show the numbers of particles (settled on the wafers) when the depth L6 of the particle generation preventing space 64 was 8.8 mm and 3.0 mm, respectively. As obvious from the graphs of Figs. 5(A) and 5(B), the numbers of particles were on the order of two or three when the depth L6 was either 8.8 mm or 3.0 mm, which are far smaller than the criterion of quality determination being thirty and are very good as compared with the result of Fig. 10 indicating the conventional case.

In the above embodiment, the inner peripheral part of the lower surface of the horizontal part 56 of the guide ring body 59 is recessed to define the particle generation preventing space 64. However, a particle generation preventing space 64 may be formed in a clamping ring for fixedly clamping a wafer W on the stage 36.

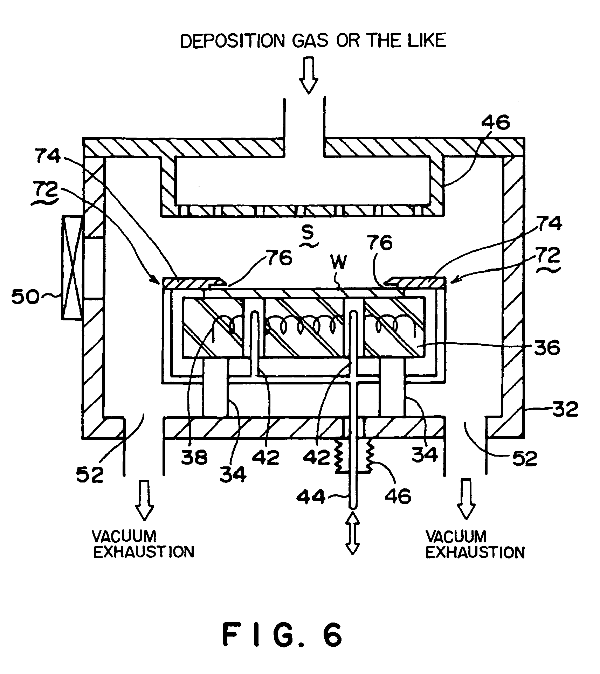

Fig. 6 is a schematic view of a film deposition system with such a manner. Elements or parts like or corresponding to those shown in Fig. 1 are denoted by the same reference characters, and the description thereof will be omitted. A clamping ring 72 has a clamping ring body 74 having a shape of a flat ring. The clamping ring 72 is adapted to move vertically together with lifter pins 42. An inner peripheral part of the lower surface of the clamping ring body 74 is brought into contact with an outer peripheral part of a wafer W, so as to clamp (press and fix) the wafer W on a stage 36. A step-like recessed surface similar to that of the guide ring 54 described in connection with Fig. 3 is formed by recessing an inner peripheral part of the lower surface of the clamping ring body 74. Thus, a particle generation preventing space 76 is formed between the recessed surface formed in the inner peripheral part of the lower surface of the clamping ring body 74 and the surface of the wafer mounted on the stage 36.

The embodiment can achieve the same effect as mentioned above with reference to Fig. 3, that is, it can be prevented that peak portions of deposited films are peeled off. Therefore, the emanation of particles can be suppressed.

Although the invention has been described as applied to the film deposition system for depositing a TiN film, the present invention is not limited thereto and can be applied to film deposition systems for depositing any kinds of films. Naturally, the present invention is applicable to film deposition systems respectively for depositing a WN film (tungsten nitride film), an SiO₂ film and the like. The object to be processed is not limited to a semiconductor wafer, and may be a substrate for an LCD or a glass substrate.

## Claims

1. A film deposition system comprising:
a processing vessel capable of being evacuated to make a vacuum therein;
a stage (36) placed in the processing vessel, capable of supporting an object to be processed on an upper surface thereof; and
a guide ring (54) placed on or above the stage (36) so as to surround an outer circumference of the object (W) to be processed mounted on the stage (36), capable of guiding the object to be processed onto the stage (36) when mounting the object to be processed onto the stage (36);
wherein a particle generation preventing space (64) is formed between an inner peripheral part of a lower surface of the guide ring (74) and the upper surface of the stage (36), and the particle generation preventing space (64) has a height of about 0.2 mm or above.

2. A film deposition system according to claim 1, wherein
the particle generation preventing space (64) is a thin annular space.

3. A film deposition system according to claim 2, wherein
the particle generation preventing space (64) has a radial dimension of about 2 mm or above.

4. A film deposition system according to any one of the preceding claims, wherein
the particle generation preventing space (64) is defined by a flat upper surface of the stage (36) and a step-like recessed portion formed at the lower surface of the guide ring (54).

5. A film deposition system according to one of the preceding claims, wherein
the particle generation preventing space has a height and a radial dimension, and
a ratio of the radial dimension to the height is 10 or above.

6. A film deposition method using a film deposition system according to one of the preceding claims , the method comprising:
a mounting step of mounting an object to be processed onto the stage;
a process-conducting step of conducting a film deposition process to the object to be processed, unnecessary films being deposited on wall surfaces defining the particle generation preventing space to form peak portions of the unnecessary films during the process-conducting step; and
a removing step of removing the object to be processed from on the stage.

7. A film deposition method according to claim 6, further comprising
a cleaning step of cleaning the film deposition system to remove the unnecessary films including the peak positions.

8. A film deposition method according to claim 7, wherein the unnecessary films peel off the wall surfaces and accumulate in the particle generation preventing space not to disperse as particles into the processing vessel, before the cleaning step.

## Patentansprüche

1. Film-Ablagerungssystem, das Folgendes umfasst:
ein Verarbeitungsgefäß, das zur Evakuation geeignet ist, um ein Vakuum darin auszubilden;
eine Station (36), die in dem Verarbeitungsgefäß angeordnet ist und geeignet ist, ein zu verarbeitendes Objekt auf einer oberen Fläche derselben zu halten; und
einen Führungsring (54), der auf oder über der Station (36) so angeordnet ist, dass er einen äußeren Umfang des zu verarbeitenden Objekts (W), welches auf der Station (36) befestigt ist, umgibt und geeignet ist, das zu verarbeitende Objekt auf die Station (36) zu führen, wenn das zu verarbeitende Objekt auf der Station (36) befestigt wird;
wobei ein Teilchenerzeugungs-Verhinderungsraum (64) zwischen einem inneren Umfangsteil einer unteren Fläche des Führungsrings (74) und der oberen Fläche der Station (36) ausgebildet ist, wobei der Teilchenerzeugungs-Verhinderungsraum (64) eine Höhe von ungefähr 0,2 mm oder mehr hat.

2. Film-Ablagerungssystem nach Anspruch 1, bei dem der Teilchenerzeugungs-Verhinderungsraum (64) durch einen dünnen ringförmigen Raum gebildet wird.

3. Film-Ablagerungssystem nach Anspruch 2, bei dem der Teilchenerzeugungs-Verhinderungsraum (64) eine radiale Abmessung von ungefähr 2 mm oder mehr aufweist.

4. Film-Ablagerungssystem nach einem der vorhergehenden Ansprüche, bei dem der Teilchenerzeugungs-Verhinderungsraum (64) durch eine ebene obere Fläche der Station (36) und einen stufenartig ausgenommenen Abschnitt, der an der unteren Fläche des Führungsrings (54) ausgebildet ist, definiert ist.

5. Film-Ablagerungssystem nach einem der vorhergehenden Ansprüche, bei dem der Teilchenerzeugungs-Verhinderungsraum eine Höhe und eine radiale Abmessung hat, und das Verhältnis von radialer Abmessung zur Höhe 10 oder mehr beträgt.

6. Film-Ablagerungsverfahren unter Verwendung eines Ablagerungssystems nach einem der vorhergehenden Ansprüche, wobei das Verfahren Folgendes umfasst:
einen Befestigungsschritt, in dem ein zu verarbeitendes Objekt auf der Station befestigt wird;
einen Prozess-Durchführungsschritt, in dem ein Film-Ablagerungsprozess an dem zu verarbeitenden Objekt durchgeführt wird, wobei unnötige Filme auf Wandflächen, die den Teilchenerzeugungs-Verhinderungsraum definieren, abgelagert werden, um während des Prozess-Durchführungsschrittes Spitzen-Abschnitte der unnötigen Filme auszubilden; und
einen Entfernungsschritt, in dem das zu verarbeitende Objekt von der Station entfernt wird.

7. Film-Ablagerungsverfahren nach Anspruch 6, das ferner einen Reinigungsschritt umfasst, in dem das Film-Ablagerungssystem gereinigt wird, um die unnötigen Filme, inklusive der Spitzen-Abschnitte, zu entfernen.

8. Film-Ablagerungsverfahren nach Anspruch 7, bei dem die unnötigen Filme von den Wandflächen abblättern und sich in dem Teilchenerzeugungs-Verhinderungsraum ansammeln, um nicht vor dem Reinigungsschritt als Teilchen in dem Verarbeitungsgefäß verteilt zu werden.

## Revendications

1. Système de dépôt de film, comprenant :
◆ une cuve de traitement, qui peut être purgée de façon à créer un vide en elle ;
◆ un étage (36), qui est placé à l'intérieur de la cuve de traitement et qui est apte à supporter un objet à traiter sur une surface supérieure de celui-ci ; et
◆ une bague de guidage (54), qui est placée sur ou au-dessus de l'étage (36) de façon à entourer une circonférence extérieure de l'objet (W) à traiter qui est monté sur l'étage (36), et qui est apte à guider l'objet à traiter sur l'étage (36) lorsque l'objet à traiter est monté sur l'étage (36) ;
dans lequel un espace de prévention de génération de particules (64) est formé entre une partie de périphérie intérieure d'une surface inférieure de la bague de guidage (74) et la surface supérieure de l'étage (36), et l'espace de prévention de génération de particules (64) a une hauteur de 0,2 mm environ, ou plus.

2. Système de dépôt de film selon la revendication 1, dans lequel : l'espace de prévention de génération de particules (64) est un espace annulaire mince.

3. Système de dépôt de film selon la revendication 2, dans lequel : l'espace de prévention de génération de particules (64) a une dimension radiale de 2 mm environ, ou plus.

4. Système de dépôt de film selon l'une quelconque des revendications précédentes, dans lequel : l'espace de prévention de génération de particules (64) est défini par une surface supérieure plane de l'étage (36), et une partie en renfoncement semblable à une marche qui est formée au niveau de la surface inférieure de la bague de guidage (54).

5. Système de dépôt de film selon l'une quelconque des revendications précédentes, dans lequel :
◆ l'espace de prévention de génération de particules a une hauteur et une dimension radiale, et
◆ un rapport de la dimension radiale à la hauteur est de 10, ou plus.

6. Procédé de dépôt de film mettant en oeuvre un système de dépôt de film selon l'une quelconque des revendications précédentes, le procédé comprenait :
◆ une étape de montage, consistant à monter un objet à traiter sur l'étage ;
◆ une étape de réalisation de traitement, consistant à réaliser un traitement de dépôt de film sur l'objet à traiter, des films inutiles étant déposés sur des surfaces de paroi qui définissent l'espace de prévention de génération de particules de façon à former des sections de crête des films inutiles au cours de l'étape de réalisation de traitement ; et
◆ une étape de retrait, consistant à retirer l'objet à traiter de l'étage.

7. Procédé de dépôt de film selon la revendication 6, comprenant par ailleurs : une étape de nettoyage, consistant à nettoyer le système de dépôt de film de façon à éliminer les films inutiles contenant les positions de crête.

8. Procédé de dépôt de film selon la revendication 7, dans lequel les films inutiles se pèlent des surfaces de paroi et s'accumulent dans l'espace de prévention de génération de particules de façon à ne pas se disperser sous forme de particules à l'intérieur de la cuve de traitement, préalablement à l'étape de nettoyage.
